# EUROPEAN PATENT APPLICATION

(11) **EP 2 194 520 A1**
(43) Date of publication of application: **09.06.2010**
(21) Application number: 09015004.6
(22) Date of filing: 03.12.2009
(51) Int. Cl.: G09F 9/35, G02F 1/133, H05K 7/20

(54) **Display apparatus and display system**

(30) Priority: 04.12.2008 JP 2008310196; 04.12.2008 JP 2008310197; 04.12.2008 JP 2008310198; 04.12.2008 JP 2008310199; 04.12.2008 JP 2008310200
(71) Applicant: SANYO Electric Co., Ltd., Moriguchi-shi Osaka 570-8677 (JP)
(72) Inventor: Nakamichi, Masaya, Moriguchi-shi, Osaka (JP); Takahashi, Shohei, Moriguchi-shi, Osaka (JP); Take, Nobuyuki, Moriguchi-shi, Osaka (JP)
(74) Representative: Glawe, Delfs, Moll

(57) **Abstract**

A display apparatus of the present invention has a display panel, an accommodating part accommodating the display panel, a circulation path surrounding the accommodating part, a heat exchanger which collects a heat from the circulation path, an electronic circuit arranged at the back side of the accommodation room, which controls the display panel, wherein, the circulation path exists between the accommodating part and the electronic circuit.

**Patent Documents cited in the description**
JP2008-310196 [0001]
JP2008-310197 [0001]
JP2008-310198 [0001]
JP2008-310199 [0001]
JP2008-310200 [0001]
JP2005-286987A [0003]

## Description

The priority application number 2008-310196, 2008-310197, 2008-310198, 2008-310199, and 2008-310200 upon which this patent application is based is hereby incorporated by reference.

### BACKGROUND OF THE INVENTION

### 1. Field of the Invention

The present invention relates to a display system, especially, a display system for outside installation.

### 2. Description of Related Art

Conventionally, plane surface type displays, such as liquid crystal displays, are widely used (for example see JP 2005-286987A). However, most of the conventional liquid crystal displays are designed for installing indoors, and the measures to protect them from a rainstorm, dust, etc. are not taken. Therefore, it was difficult to place the liquid crystal display outdoors permanently.

However, in recent years, it is desired to place the liquid crystal displays permanently on outdoors, because the thickness of the displays are small and can display high resolution pictures. If thickness is small, it can be installed to the outer wall of buildings, or to narrow places such as bus stops. Moreover, if the resolution of a display is high, it can display a clear picture even if the screen size is small.

Therefore, in order to protect these liquid crystal displays from rainstorms etc., it is considered to arrange a display panel, which is easy to damage, inside an accommodation room having a waterproofing structure.

However, if a display panel is arranged inside the accommodation room, heat cannot escape outside, so it is difficult to cool the panel in the course of the nature. Therefore, the temperature of the panel may rise when it is driven, or may rise by sunlight. As a result, it may not be able to display a picture (which is called a "blackout") because of degradation of the function of the liquid crystal.

Moreover, the heat generated from the display panel may raise the temperature of the circuit board controlling the panel. When the panel is operating, the temperature of the circuit board rises by the heat from itself. So, if the heat from the panel is added to the circuit board, the temperature of the circuit board may rise excessively and the circuit board may be damaged.

In order to cancel these problems, it is desired to cool those panels and circuit boards. However, since the heat generated from the panel is large, it was difficult to cool both the panel and the circuit board efficiently.

### SUMMARY OF THE INVENTION

A display apparatus of the present invention has a display panel, an accommodating part accommodating the display panel, a circulation path surrounding the accommodating part, a heat exchanger which collects a heat from the circulation path, an electronic circuit arranged at the back side of the accommodation room, which controls the display panel, wherein, the circulation path exists between the accommodating part and the electronic circuit.

### BRIEF DESCRIPTION OF THE DRAWINGS

FIG.1 is a perspective diagram showing the display system having a display apparatus.
FIG.2 is an exploded perspective view of a display system.
FIG.3 is a perspective diagram showing the waiting room unit installed in the stop of transportation facilities.
FIG.4 is a sectional view along the IV-IV line shown in FIG.2.
FIG.5 is a sectional view along the V-V line shown in FIG.4.
FIG.6 is a sectional view along the VI-VI line shown in FIG.4.
FIG.7 is a sectional view along the VII-VII line shown in FIG.4.
FIG.8 is a two-dimensional diagram of this display system.
FIG.9 is an enlarged view of IX area shown in FIG.5.
FIG.10 is the perspective diagram when fractured along X-X-rays shown in FIG.4.
FIG.11 is the perspective diagram when fractured along XI-XI line shown in FIG.4.
FIG.12 is a sectional view along the XI-XI line shown in FIG.4.
FIG.13 is an enlarged view of the XIII area shown in FIG.12.
FIG.14 is an enlarged view of the XIV area shown in FIG.12.
FIG.15 is a perspective diagram of the back side of the back wall of an accommodation room, viewing from the bottom side in the state where an evaporator is eliminated.
FIG.16 is a perspective diagram of the back side of the back wall, viewing from the upper side.
FIG.17 is an exploded perspective view of a radiating fin.
FIG.18 is a perspective diagram showing the second radiation part constituting a radiating fin.
FIG.19 is an expansion perspective diagram showing the principal part of a radiating fin.
FIG.20 is a perspective diagram of the back side of the back wall of an accommodation room, viewing from the bottom side.
FIG.21 is a perspective diagram showing the state before attaching a display apparatus to a support stand.
FIG.22 is a two-dimensional diagram showing the frame part of a support stand.
FIG.23 is a perspective diagram showing a first state of the engaging component and the engaged component, when attaching a display apparatus to a support stand.
FIG.24 is a perspective diagram showing a second state of the engaging component and the engaged component, when attaching a display apparatus to a support stand.
FIG.25 is a perspective diagram showing a third state of the engaging component and the engaged component, when attaching a display apparatus to a support stand.
FIG.26 is a sectional view showing a display system of the modification 6.

### DETAILED DESCRIPTION OF THE INVENTION

The present invention embodied in a display apparatus or display system will be specifically described below with the reference to the drawings.

### [1. Outline of the display system]

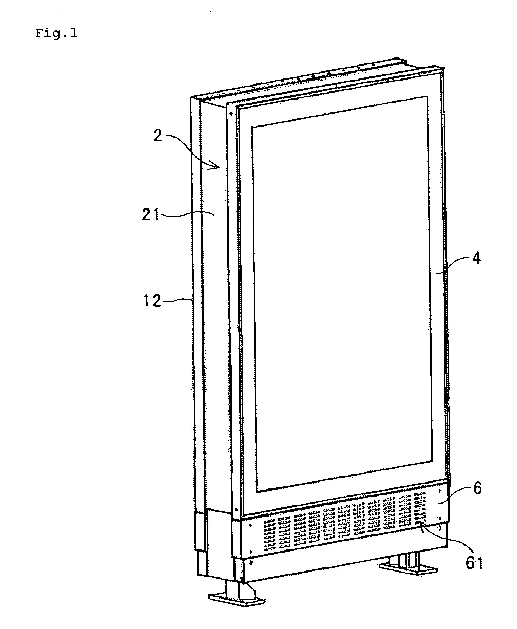

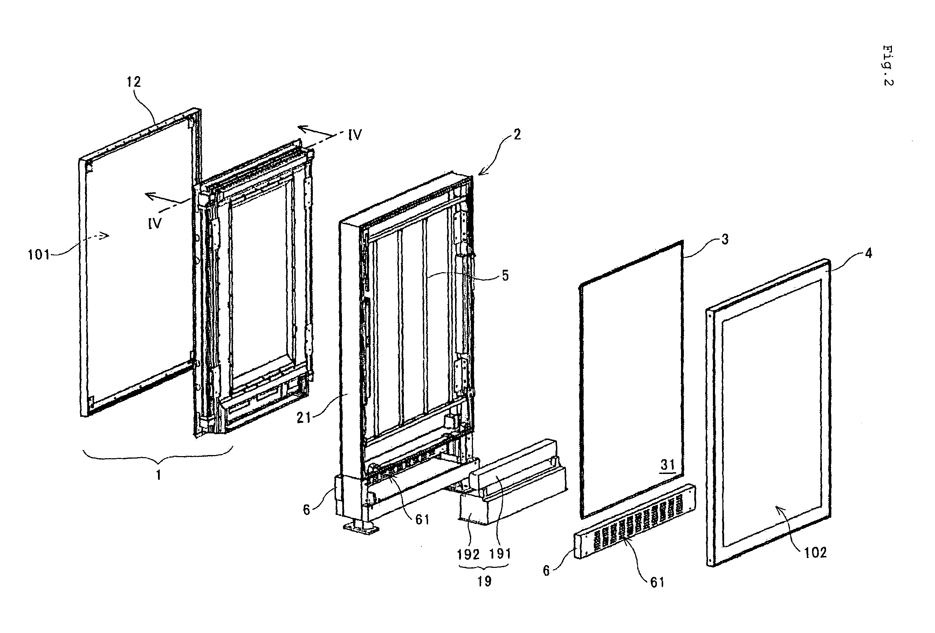

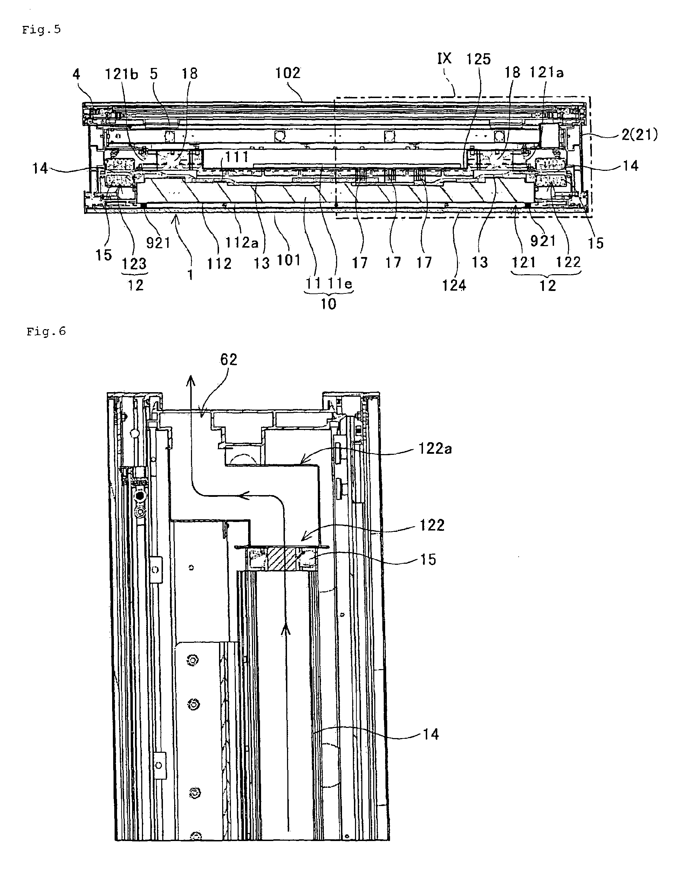

As shown in FIG.1 the display system has a flat rectangular appearance, and as shown in FIG.2, it has a display apparatus 1, support stand 2, backboard 3, cover 4, fluorescent light fittings 5, and pair of aeration plates 6, 6. The display apparatus 1 displays an image on the surface 101 of the display system, and has a liquid crystal display 10 as shown in FIG.5. The detail of the display apparatus 1 is explained later on a section 2 "A display apparatus".

The support stand 2 supports the display apparatus 1 and the backboard 3, and a frame part 21 for attaching the display apparatus 1 and the backboard 3 is formed. The frame part 21 has a structure that can insert the display apparatus 1 and the backboard 3. The structure for attaching the display apparatus 1 to the support stand 2 is explained later on a section 3 "Composition for attaching a display apparatus to a support stand".

The backboard 3 is an installation stand for attaching an advertisement, and is installed in the frame part 21 at the back side of the display apparatus 1. The advertisement is attached on the surface 31 of the backboard 3, which is a back surface 102 of a display system. Here, the backboard 3 is formed from a material having an optical transparency in order to transmit a light emitted from the fluorescent light fittings 5. The advertisement attached to the backboard 3 is also formed from a material having an optical transparency as well. Hereafter, such advertisement is called "advertising film".

The cover 4 is attached to the support stand 2 in openable and closable state, and it covers the surface 31 of backboard 3 when it is closed. Thereby, the advertisements can be protected by the cover 4. The portion which faces the surface 31 among the covers 4 is formed with a material having an optical transparency. Thereby, the advertisement can be seen from the back side 102 of the display system.

The fluorescent light fitting 5 is an instrument which illuminates the advertising film attached on the surface 31, and is constituted by a plurality of fluorescent lights prolonged in the perpendicular direction. The fluorescent light fitting 5 is attached to the frame part 21 between the display apparatus 1 and the backboard 3. The detailed position of arranging of the fluorescent light fittings 5 is explained later by section 4 "The arrangement of the fluorescent light fitting". By illuminating an advertising film with the fluorescent light fittings 5, characters printed on the advertising film can be seen even at nighttimes.

A pair of aeration plates 6, 6 is arranged at the front 101 and the back 102 of the display system respectively, at the bottom part of the display apparatus 1. In the aeration plates 6, a plurality of vents 61, which aerate the inside and the outside of the display system are formed.

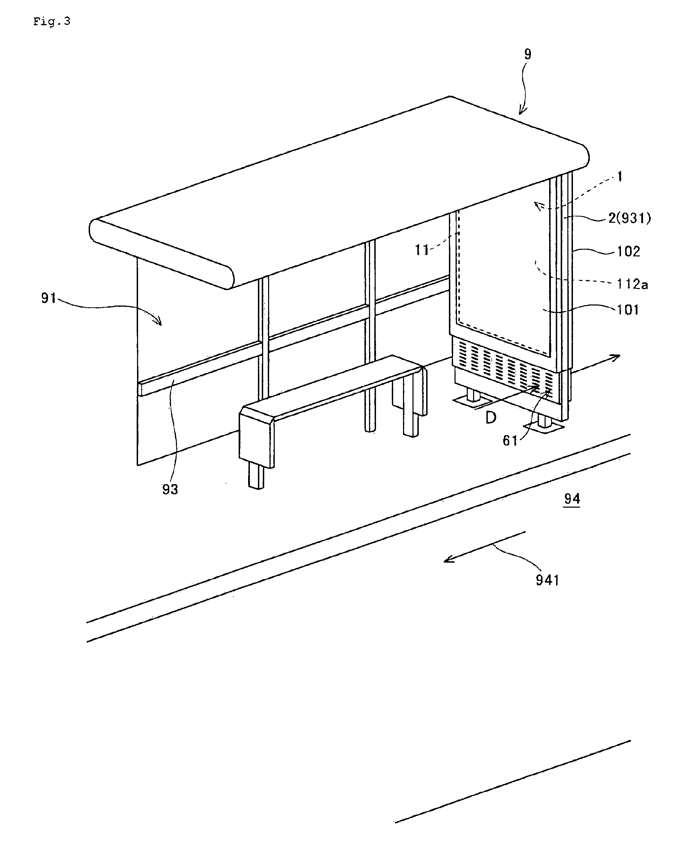

The display system mentioned above can be installed in a stop of public transportations such as bus stops, as shown in FIG.3. According to this system, it can offer many kinds of information to the people waiting at the stop using still pictures or animations. The installation state of a display system is explained later on section 5,"The installation state of a display system".

By operating a display system by remote control in a cable or a wireless communication, information displayed on the screen 112a can be updated. Furthermore, when display systems are installed in each of the bus stops, those display systems can be managed collectively.

### [2. Display apparatus]

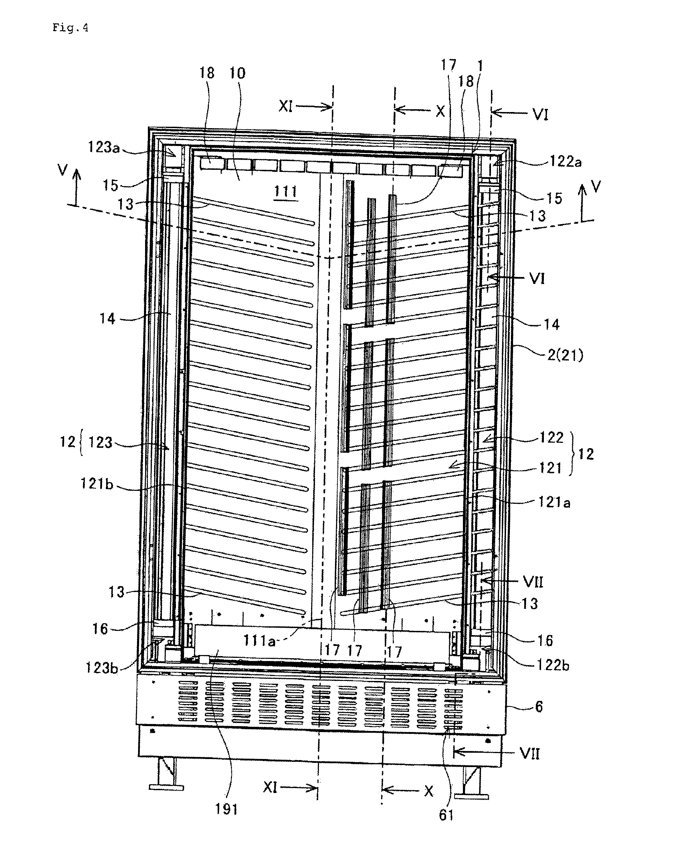

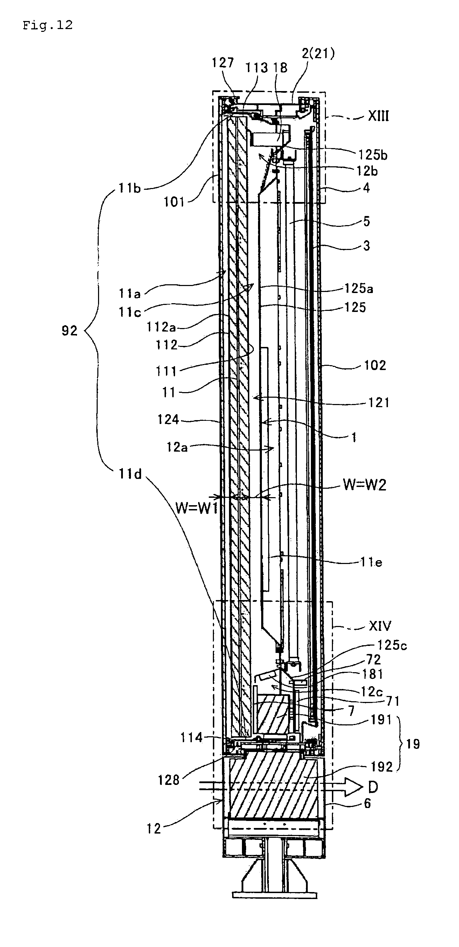

As shown in FIG.4 and FIG.5, the display apparatus 1 has a liquid crystal display 10, a housing 12, a plurality of heat pipes 13, a circulation fan 18, a radiating fin 14, aeration fans 15 and 16, and a heat collecting fin 17. Furthermore, as shown in FIG.12, the display apparatus 1 also has an air conditioner 19, a circulation fan 181, a Heat insulating component 7, and heat collecting fin 71 and ventilation fan 72 for circuit boards.

### (Liquid crystal display 10)

The liquid crystal display 10 is a plane surface type display, and as shown in FIG.5, it has a display panel 11, and a circuit board 11e for controlling the display panel 11. The display panel 11 is arranged inside the accommodation room 121 mentioned later. The circuit board 11e is arranged at the back of the back wall 125 of the accommodation room 121.

According to its usage, various form of display panel 11 can be used. In this embodiment, the display panel 11 has a vertically long rectangular shape so that it can be installed in narrow places such as bus stops. Further, the display panel 11 tends be high temperature, because it tends to generate heat especially on the surface 112 where the display screen 112a is formed.

### (Housing 12)

The housing 12 has a waterproofing structure, and the accommodation room 121 is formed inside the housing 12 as shown in FIG.4. Inside the accommodation room 121, the display panel 11 is arranged so that the display screen 112a faces the surface 101 of the display system, as shown in FIG.12.

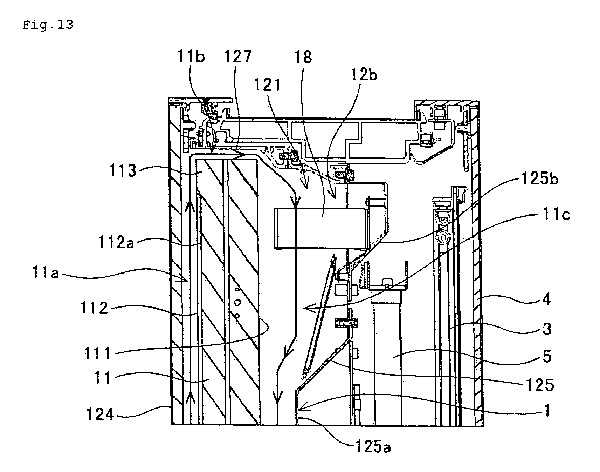

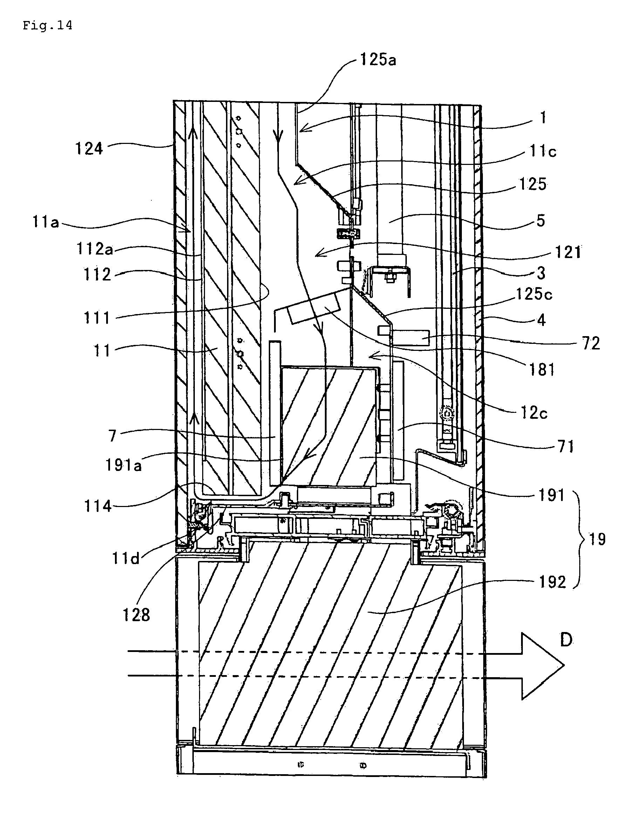

As shown in Fig.4 or Fig.12, the housing 12 has a surface wall 124 on the surface 112 side of the display panel 11, a back wall 125 on the back side 111 of the panel 11, side walls 121a and 121b on the both sides of the panel 11, an upper surface wall 127 on the upper end side 113 of the panel 11 (see FIG.13 as well), and an undersurface wall 128 on the bottom side 114 of the panel 11 (see FIG.14 as well). The accommodation room 121 is constituted by the surface wall 124, the back wall 125, the side walls 121a and 121b, the upper surface wall 127, and the undersurface wall 128 and is maintained in the sealed or almost sealed state.

By maintaining the accommodation room 121 in a sealed state, and by accommodating the display panel 11 inside the accommodation room 121, the display panel 11 can be protected from rainstorms or dusts even when the display apparatus 1 is installed outdoors.

In this embodiment, as shown in FIG.12, the back wall 125 is arranged away from the back 111 of the display panel 11 between the display panel 11 and the backboard 3. Thereby, it is hard for the heat generated from the display panel 11 to spread to the back wall 125, and small the heat of the display panel 11 hardly spreads to the circuit, and accordingly a few heat transmits to the circuit board 11e arranged at the back of the back wall 125. As a result, it can prevent the excessive heating of the circuit board 11e, and can prevent from being damaged.

Among the surface walls 124, a portion facing the display screen 112a is formed by material having an optical transparency such as glass materials. The surface of the surface wall 124 is identical to the surface 101 of the display system. Thereby, it is able to see the display screen 112a from the surface side of the case 12. (Circulation path)

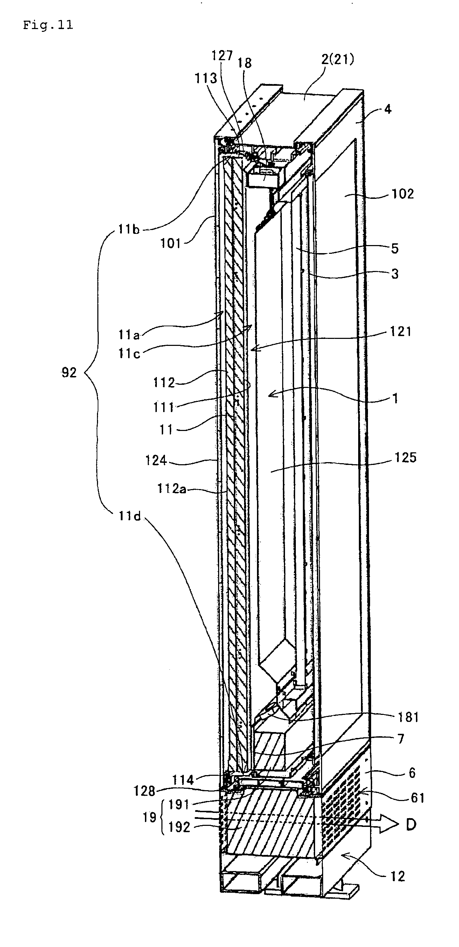

As shown in FIG.11 and FIG.12, the circulation path 92 surrounding the display panel 11 is formed inside the accommodation room 121. In FIG.11 and FIG.12, in order to clarify the circulation path 92, an illustration of the heat pipes 13 and the heat collecting fins 17 are omitted. It is as well in FIG.13 and FIG.14 mentioned afterwards.

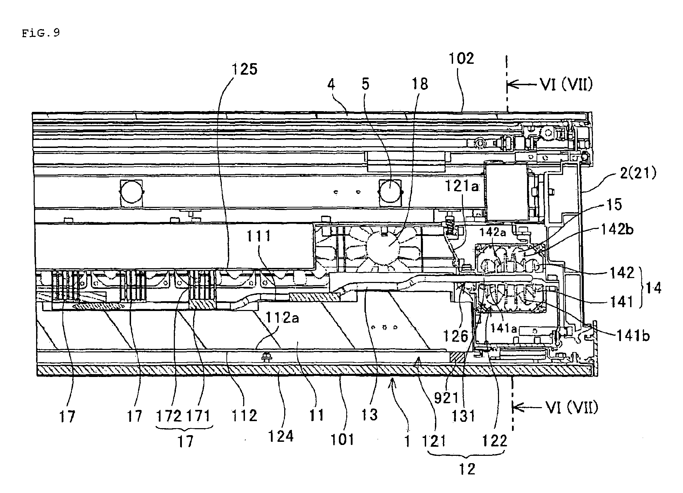

In this embodiment, a circulation path 92 is constituted by four path parts 11a to 11d. The path part 11a is formed between the surface wall 124 of the accommodation room 121, and the surface 112 of the display panel 11, and is stretched along the surface 112 in a perpendicular direction. In detail, a pair of path formation components 921, 921 for forming the path part 11a is arranged on the surface 112. The pair of path formation components 921, 921 is stretched along the surface 112 in a perpendicular direction and is intervened by the surface wall 124 and the surface 112 on both sides of the display screen 112a (see FIG.9). Thus, the path part 11a is formed, surrounded by the components 921,921, the surface wall 124, and the surface 112.

Additionally, as shown in FIG.13, a path part 11b is formed between the upper surface wall 127 of the accommodation room 121, and the upper end side 113 of the display panel 11. The path part 11c is formed between the back wall 125 and the back 111,and is stretched along the back 111 in the perpendicular direction. The path part 11d is formed between the undersurface wall 128 and the lower end side as shown in FIG.14.

In this embodiment, the width W of the path part 11a (to the direction perpendicular to the outer surface of the display panel 11, see FIG.12) is smaller than that of the path part 11c. For example, the width W of the path part 11a is about 10 mm. Similarly, width W of the path parts 11b and 11d are about 10 mm.

The path parts 11a, 11b, 11c, 11d are annularly connected in this order around the display panel 11, and are surrounding the display panel 11. In other words, the path part 11a and the path part 11c are connected via path part 11b or path part 11d in the upper part or lower part respectively. The air in the circulation path 92 circulates the surroundings of the display panel 11 by circulation fans 18 and 181 mentioned later. Therefore, the heat generated in the display screen 112a moves to the back 111 side.

### (Aeration way)

Inside the case 12, the aeration ways 122 and 123 leading to the outside of the housing 12 is formed outside of the accommodation room 121. As shown in FIG.4, the aeration way 122 stretches along the side wall 121a which is one side wall of the accommodation room 121 in the perpendicular direction, and the aeration way 123 stretches along the side wall 121b, a side wall of the another side. Hence, by forming the aeration ways 122 and 123 in both sides of the accommodation room 121, it can prevent the thickness of a display apparatus 1 being large.

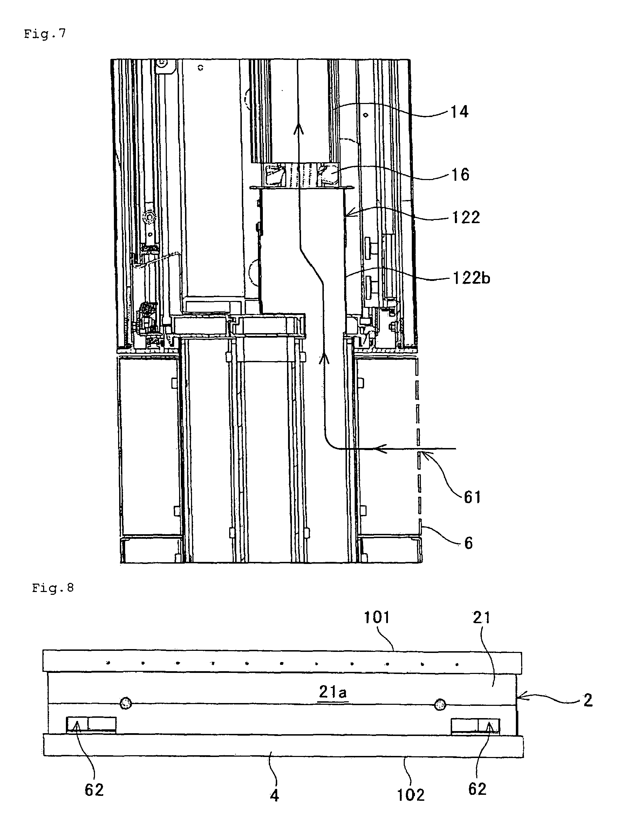

The upper end 122a of the aeration way 122 is bent in a cranked shape as shown in FIG.6, and it leads to the outside of the housing 12 through the vent 62 (see FIG.8) provided in the upper surface 21a of the frame part 21 of the support stand 2. It is as well for the upper end 123a of the aeration way 123. As shown in FIG.7, the lower end part 122b of the aeration way 122 leads to the outside of the housing 12 through the vent 61 of the aeration plates 6 which is installed under the display apparatus 1. It is as well for the lower end part 123b of the aeration way 123.

### (Heat pipe 13)

A plurality of heat pipes 13 are arranged in the path part 11c of the circulation path 92. As shown in FIG.4, a plurality of heat pipes 13 is fixed to the back 111, in a predetermined interval to perpendicular direction. In this embodiment, such heat pipes 13 are arranged on the both sides of the central line 111a of the back 111 in pairs.

As shown in FIG.9, a heat pipe 13 arranged at the aeration way 122 side of the central line 111a is stretched from the back 111 of the display panel 11 to the aeration way 122,and penetrates a side wall 121a of the accommodation room 121, and is stretched to the outside of the accommodation room 121. In detail, the heat pipe 13 is stretched from the inside of the accommodation room 121 to the inside of the aeration way 122. In other words, the heat pipe 13 is arranged, protruding to the aeration way 122.

In detail, as shown in FIG.9, the penetration hole 126 is formed in the side wall 121a of the accommodation room 121, and the heat pipe 13 is stretched from the inside of the accommodation room 121 to the inside of the aeration way 122 via the penetration hole 126.

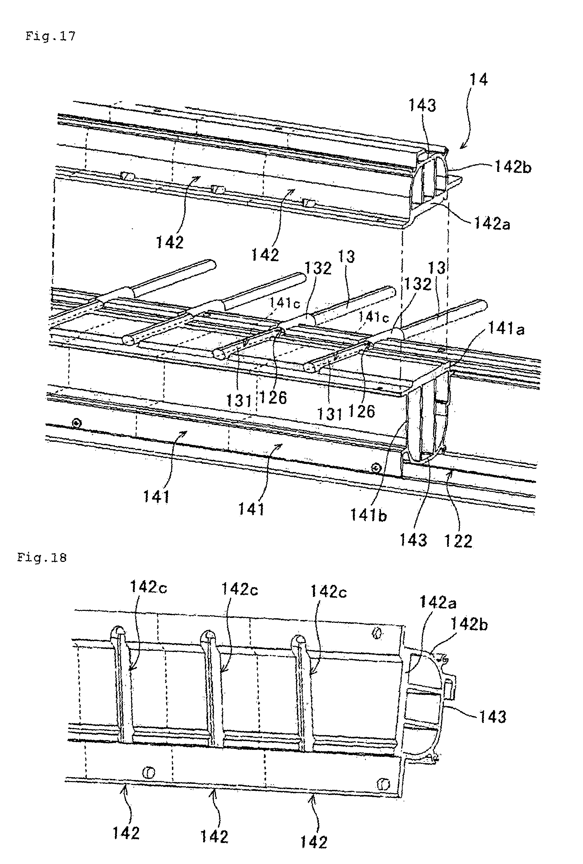

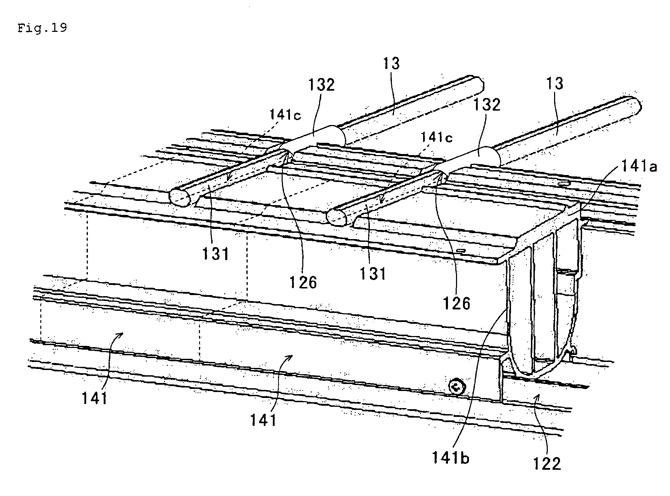

As shown in FIG.17 and FIG.19, the annular seal component 132 consists of silicon rubber etc. is fit to the heat pipe 13, and the penetration hole 126 is sealed by the seal component 132 fitted to the heat pipe 13 in the state where the heat pipe 13 is penetrated. Thereby, the inside of the accommodation room 121 is maintained at a sealing state.

The heat pipe 13 arranged at the aeration way 123 side of the central line 111a stretches to the inside of the aeration way 123 from the inside of the accommodation room 121 (see FIG.5) via side wall 121b as well as a heat pipe 13 stretched to the aeration way 122.

According to the above heat pipe 13, the heat generated from the display panel 11 is collectable inside the accommodation room 121. Hence, the heat of air in the circulation path 92 can be collected by the heat pipe 13, and the heat from the display panel 11 can be collected directly from the back 111. The collected heat is led outside of the accommodation room 121 by the heat pipe 13, and is emitted to the inside of the aeration ways 122 and 123. In other words, the heat pipe 13 functions as a heat exchanging means in a display apparatus 1.

The heat emitted into the aeration way 122 and 123 from the heat pipe 13 is diffused outside the housing 12 via aeration ways 122 or 123. Hence, the aeration ways 122 and 123 function as heat collecting means which collect heat from the heat pipe 13. Accordingly, the rise in the temperature of the display panel 11 is suppressed and the function of the liquid crystal display 10 can be maintained in a good state.

In this embodiment, since the heat pipes 13 are arranged at the predetermined intervals at the back 111 of the display panel 11, heat can be collected from the whole path part, and can be collected from the whole back 111 side of a liquid crystal display. Thereby, the cooling efficiency of the display apparatus 1 becomes high.

The temperature in the accommodation room 121 become higher than the outside (i.e. aeration ways 122 and 123) when the display panel 11 generates heat. Additionally, coolant for heat exchange (such as waters) is filled up inside the heat pipe 13. Therefore, from a view of raising a heat exchange efficiency of the heat pipe 13, it is desirable to arrange the heat pipes 13 so that they extends obliquely upward toward the aeration way 122 or 123 from inside of the accommodation room 121 as shown in FIG.4.

Thereby, the position of the heat pipe 13 in the aeration way 122 or 123 (a low temperature portion) become higher than the position of the heat pipe 13 inside the accommodation room 121 (a high temperature portion). Accordingly, the coolant in the heat pipe 13 is evaporated at a high temperature portion and rises above toward the low temperature portion, then liquefied in the low temperature portion, and falls off to the high temperature portion and again evaporated in the high temperature portion. Thus, arranging the heat pipe 13 oblique, the coolant can circulates inside the heat pipe 13 and the heat exchange efficiency of the heat pipe 13 can be raised.

Further, in this embodiment, since the heat pipe 13 is arranged at the back 111 of the display panel 11, the restriction when arranging the heat pipe 13 at the surface 112 side (i.e. inside the path part 11a) such as reduction of the display screen 112a, enlargement of a display apparatus 1, etc. are prevented. Thus, the heat exchange efficiency in the heat pipe 13 is high even if the heat pipe 13 is arranged at the back 111 because the heat generated in the display screen 112a is led to the heat pipe 13 by the air circulating the circulation path 92.

From a viewpoint of raising the collecting efficiency of the heat from the back 111 of the display panel 11, each of the heat pipes 13 is arranged along the back 111 of the display panel 11.

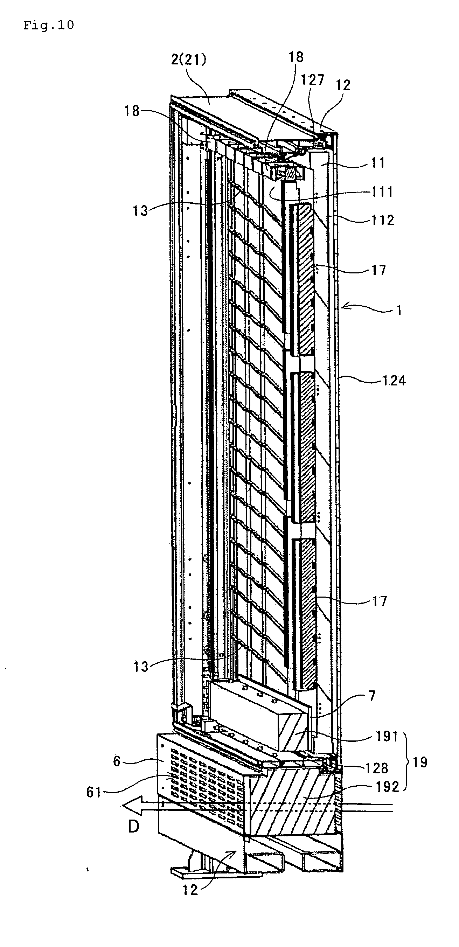

In this embodiment, from the relation between the attachment position of the display panel 11 and electronic component or the circuit board 11e mounted in the display apparatus 1, a step exists in the back 111 of the display panel 11 as shown in FIG.5 and FIG.10, Even if such step exists, the heat pipes 13 are bent in crank shape at the step portion so that the heat pipes 13 can go along the back 111 of the display panel 11.

Thereby, it can reduce a useless space produced by disposition of the heat pipe 13. Moreover, since the contacting area with the back 111 of the display panel 11 increases, the heat exchange efficiency between the heat pipe 13 and the display panel 11 increases, and as a result, the heat collecting efficiency at the back 111 of the display panel 11 becomes high.

Further, in this embodiment, the heat pipes 13 are repeatedly arranged in intervals of predetermined in the perpendicular direction as shown in FIG.4, and are extended to the inside of the aeration way 122 or 123, maintaining the distance with the adjacent heat pipe 13 at the predetermined interval. Therefore, the heat collected by the heat pipe 13 can be exhausted in a distributed manner inside the aeration way 122 and 123, and as a result, the heat exchange (or heat dissipation) efficiency of the heat pipe 13 inside the aeration ways 122 and 123 can be increased.

### (Air conditioner 19)

The air conditioner 19 has an evaporator 191 and a condenser 192 as shown in FIG.2, FIG.10, FIG.11, and FIG.12. Moreover, the air conditioner 19 also has a compressor which is not illustrated. The evaporator 191 cools the air circulating the circulation path 92 and returned to the air conditioner 19. The cooled air is again sent to the circulation path 92. The compressor compresses the coolant which flows inside the evaporator 191. The condenser 192 cools the coolant having a high temperature and pressure compressed by the compressor, and generates a liquefied coolant. When the liquefied coolant flows through the evaporator 191, the evaporator 191 can cool the air.

As shown in FIG.11 and FIG.12, the evaporator 191 is arranged at the back 111 side of the display panel 11 near the undersurface 114 of the display panel 11. In other words, the evaporator 191 is arranged at the lower end part of the path part 11c. By arranging the evaporator 191 as such, it can avoid the display apparatus 1 being enlarged in the height direction. Further, by arranging the evaporator 191 to the back 111 side instead of the undersurface side 114 of the display panel 11, the circulation path 92 can be shortened.

The evaporator 191 may be arranged at the lower part of the display panel 11, i.e., the undersurface 114 side of the display panel 11 instead.

Further, as shown in FIG.14, the evaporator 191 near the back wall 125 of the accommodation room 121 at the lower end part of the path part 11c. Thereby, the domain near the lower end of the back wall 125 is cooled with the evaporator 191.

As shown in FIG.11 and FIG.12, the condenser 192 is arranged in the housing 12 and outside the accommodation room 121. Specifically, the condenser 192 is arranged between a pair of aeration plates 6, 6 under the accommodation room 121 (i.e., the lower part position of the display panel 11).

Moreover, between a pair of aeration plates 6, 6, an air intaking and exhausting fan is stationed (not illustrated). This fan inhales an air from the vent 61 formed in one of the aeration plate 6 and sends the air into the condenser 192 then discharges the air from the vent 61 in the aeration plate 6 of the another side. Thereby, the heat exhausted from the condenser 192 can be efficiently emitted outside the case 12.

According to the air conditioner 19, the heat generated from the display panel 11 is collected, and the temperature rise in display panel 11 is suppressed.

Further, in this embodiment, since the area near the lower end of the back wall 125 is cooled with the evaporator 191, the heat from the circuit board 11e can be collected by using the evaporator 191 for collecting the heat of the display panel 11. Further, as mentioned above, the heat generated by the display panel 11 hardly reaches the circuit board 11e. Therefore, a cooling of the circuit board 11e can be efficiently performed by the evaporator 191. Further, in this embodiment, it can cool the circuit board 11e efficiently using the evaporator 191 by the heat collecting fin 71 and the ventilation fan 72 for circuit boards.

In this embodiment, though, the evaporator 191 is used as a heat exchanging means collecting heat from the air in the circulation path 92, and the condenser 192 is used as a heat exchanging means to emit the heat collected by the evaporator 191 outside the case 12, the other heat exchange means may be used instead. Further, in this embodiment, though the air intaking and exhausting fan is used as a means for air intaking and exhausting from the vent 61, the other means may be used as well.

Furthermore, in this embodiment, the aeration plate 6 and the housing 12 are formed as different components, and the vent 61 is formed in the aeration plate 6. However, the vent 61 may be formed in the case 12 without forming the aeration plate 6.

### (Circulating fan 18,181)

The circulating fan 18, 181 are fans for circulating the air in the circulation path. The circulating fan 18 is arranged at the back 111 side of the display panel 11, near the upper surface 113 of the display panel 11, as shown in FIG.11 and FIG.12. In other words, the circulating fan 18 is arranged at the upper end of the path part 11c of the circulation path 92. And the circulating fan 18 passes the air in the path part 11c to the lower portion, as shown in FIG.13.

The circulating fan 181 is arranged at the back 111 side of the display panel 11, and near the evaporator 191, in the accommodation room 121. In this embodiment, as shown in FIG.11 and FIG.12, the circulating fan 181 is arranged above the evaporator 191 in the lower end of the path part 11c, and sends an air towards the evaporator 191, as shown in FIG.14.

Thereby, the air in the circulation path 92 circulates around the display panel 11 in the direction of a solid line arrow, as shown in FIG.13 and FIG.14. Hence, by driving the circulating fan 18,181, the air in the path part 11a can flow from bottom up in the perpendicular direction, as shown in FIG.13. And the air passes along the path part 11b, and flows into the path part 11c. Then the air flows downward along the path part 11c, as shown in FIG.14, and returns to the path part 11a through the path part 11d.

According to the circulating fan 18,181, the air in the path part 11a along the surface 112 of the display panel 11 can be efficiently led to the path part 11c along the back 111. Therefore, the heat generated in the display screen 112a of the display panel 11 can be led to the heat pipe 13 and the evaporator 191 arranged at the back 111 side of the display panel 11 through the air, and the heat is efficiently collected by the heat pipe 13 and the evaporator 191. Hence, the display panel 11, especially the display screen 112a can be cooled using the air of circulation path 92. Therefore, the heat rise of the display panel 11, especially the display screen 112a which tends to generate heat, can be suppressed.

Moreover, the heat generated from the circuit board 11e is also transmitted from the surface of the back wall 125 to the air in the circulation path 92, and is collected by the heat pipe 13 and the evaporator 191. Thus, the circuit board 11e is also cooled.

Therefore, considering that the display panel 11 and the circuit board 11e are cooled with the circulating fans 18,181, the heat pipe 13, and the evaporator 191, it can be said that the cooling system is constituted by the circulating fan 18,181, the heat pipe 13, and the evaporator 191.

Since an air is sent to the evaporator 191 by the circulating fan 181 (see FIG.14), the air of the circulation path 92 can be sent to the evaporator 191 without making stagnation in the path part 11c. Therefore, heat is efficiently collectable with the evaporator 191.

Additionally, since the circulating fan 18,181 is arranged at the upper end and the lower end of the path part 11c respectively, the air can easily flow along the circulation path 92, and the flow velocity becomes large. Therefore, the display panel 11 can be cooled efficiently.

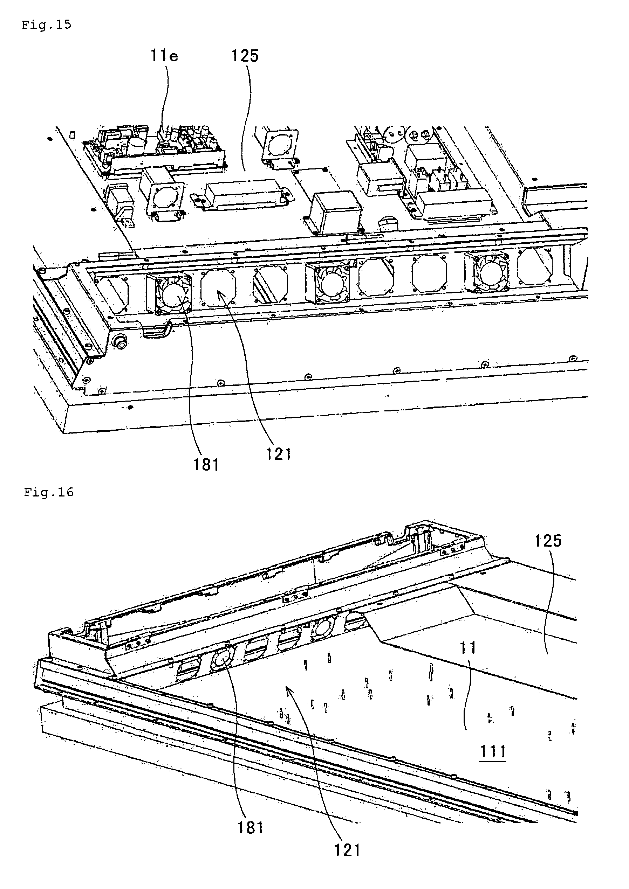

However, if the flow velocity of the air is too large, the heat exchange efficiency in the heat pipe 13 or the evaporator 191 degrades. Therefore, it is desirable to arrange ten circulating fans 18 at the upper end of the path part 11c as shown in FIG.4, and three circulating fans 181 at the lower end part of the path part 11c as shown in FIG.15 and FIG.16.

In this embodiment, since the width W1 of the path part 11a is smaller than the width W2 of the path part 11c (see FIG.12), the velocity of the air flowing along the circulation path 92 becomes larger in the path part 11a. Therefore, the heat quantity led to the heat pipe 13 and the evaporator 191 from the display screen 112a of the display panel 11 becomes large, and the cooling efficiency of the display screen 112a increases.

Further, in this embodiment, since the air of the path part 11a along the surface 112 of the display panel 11 flows from bottom up, which corresponds to the warm air's nature, the air in the path part 11a can flow upwards efficiently. Therefore, an air can easily circulate the circulation path 92, and the heat generated in the display screen 112a of the display panel 11 can be led efficiently to the heat pipe 13 and the evaporator 191. As a result, the heat exchange efficiency or heat collecting efficiency at the heat pipes 13 and the evaporator 191 increase. Accordingly, the cooling efficiency of the display apparatus 1 increases.

Further, since the circulating fan 18 is arranged at the upper end part of path part 11c, which is a position where the air flows out from the path part 11b, and flows the air in the path part 11c to the downwards, the air can be circulated efficiently in the circulation path 92. The detail is explained as below.

In the circulation path 92, a path resistance becomes high in a narrow portion, and the path resistance becomes low in a wide portion. Therefore, the air in the narrow portion tends to flow into the wide portion. As shown in FIG.13, the width of the path parts 11a and 11b are narrower than that of the path part 11c. Therefore, path resistance of the path parts 11a and 11b becomes higher than that of the path part 11c. As a result, the air in the path parts 11a and 11b tends to flow into the path part 11c.

Therefore, by arranging the circulating fan 18 at where the air flows out of the path part 11b, or at its vicinity, and passing the air in the path part 11b to the path part 11c, the air in the path part 11b can be efficiently led to the path part 11c. As a result, the air in the circulation path 92 circulates efficiently.

Similarly, when the width W (=W2) of the path part 11b is wider than the width W (=w1) of the path part 11a, the circulating fan 18 may be arranged where the air flows out of the path part 11a, or its vicinity.

Further, in this embodiment, since the circulating fan 18,181 are arranged at the back 111 side of the display panel 11, it can avoid the display apparatus 1 being expanded in the height direction.

Although the circulating fan 18,181 is used as a circulation means for circulating the air in the circulation path 92 in this embodiment, the other circulation means may be adopted.

### (Radiating fin 14)

The radiating fin 14 is arranged in the aeration way 122, as shown in FIG.9, and is connected to the protrusion part 131 which is the portion protruded into the aeration way 122 among the heat pipes 13. In this embodiment, the radiating fin 14 is formed by aluminum.

Specifically, the radiating fin 14 is constituted by the first radiating part 141 and the second radiating part 142 which sandwiches the protruding part 131. The first radiating part 141 has a base 141a and a fin part 141b connected perpendicularly to the base 141a, and is arranged at the front side of the housing 12 against the protrusion part 131, in other words the surface 101 side of the display system. The second radiating part 142 has a base 142a and a fin part 142b connected perpendicularly to the base 142a and is arranged at the back 102 side directions of the housing 12 against the protruding part 131, in other words, the back 102 side of the displaying system.

As shown in FIG.17 and FIG.18, in each of the radiating parts 141 and 142, a pair of grooves 141c and 142c is formed in the bases 141a and 142a respectively. When sandwiching the protruding part 131 by the radiating parts 141 and 142, it fits into the grooves 141c and 142c. Specifically, grooves 141c and 142c are half cylinder shaped, and when the protruding part 131 is sandwiched by these radiating parts, a cylindrical hole is formed by these grooves, and as a result, the protruding part 131 fits into this cylindrical hole.

In this embodiment, while heat pipes 13 are arranged side by side in the perpendicular direction at the back 111 of the display panel 11 (see FIG.4), radiating fins 14, which corresponds to each of the heat pipes 13, are arranged in the perpendicular direction in the aeration way 122. Further, as shown in FIG.17 and FIG.18, first radiating parts 141 corresponding to each heat pipes 13 are formed in a combined form, plural second radiating parts 142 corresponding to each heat pipes 13 are also formed in combined form.

In the aeration way 123, the radiating fins 14 are arranged also (for example, see FIG.4), as well as in the aeration way 122.

According to the above mentioned radiating fin 14, the heat dissipation efficiency from the heat pipe 13 to into the aeration way 122 and 123 increases, and, as a result, the cooling efficiency of the display apparatus 1 increases.

In this embodiment, since the radiating fin 14 is constituted by the first radiating part 141 and the second radiating part 142, and grooves 141c and 142c are formed in each of them, the radiating fin 14 can be connected to the heat pipe 13 by sandwiching it with radiation parts 141 and 142 from the both side, and by fitting the heat pipe 13 into the pair of grooves 141c and 142c. Therefore, it is easy to connect the radiating fin 14 to the heat pipe 13.

Further, according to this embodiment, since first radiating parts 141, which corresponds to each of the heat pipes 13, are formed in one, and second radiating parts 142, which corresponds to each of plural heat pipes 13, are also formed in one, the radiating fins 14 can be attached to all of the heat pipes 13 by a single operation (i.e. sandwiching the plural heat pipes 13 by the first radiating part 141 and the second radiating part 142). As a result, the attachment of the radiating fins 14 to the heat pipes 13 is simplified.

In this embodiment, as shown in FIG.17, plural fin parts 141b are connected perpendicularly to the base 141a in the first radiating part 141, and interspaces are formed among fin parts 141b. It is as well in the second radiating part 142. Further, the air in the aeration way 122,123 flows through the interspaces.

Further, in FIG.17, tips of fin parts 141b are mutually connected by the connection part 143 in the first radiating part 141, and the above mentioned interspaces is surrounded by the fin part 141b, the base 141a, and the connection part 143. It is as well in the second radiating part 142. In this case, the radiating fins 14 can be used as duct fins by letting the air in the aeration way 122 or 123 pass these interspaces. Or instead, the air in the aeration way 122 or 123 may be passed both inside and outside of the interspaces as well.

In this embodiment, the radiating fins 14 are used as radiation components for raising the radiating efficiency from the heat pipe 13 to the aeration way 122 and 123. Instead, the other type of radiating components may be adopted. (Aeration fans 15 and 16)

The aeration fans 15 and 16 are arranged in the aeration way 122, as shown in FIG.4. The aeration fan 15 is arranged at the upper end 122a of the aeration way 122, and the aeration fan 16 is arranged at the lower end 122b of the aeration way 122.

The aeration fans 15 and 16 pass the air in the aeration way 122 to the same direction along the aeration way 122. That is, the aeration fan 15 passes the air in the aeration way 122 from bottom up, by emitting the air to the outside of the housing 12 from the vent, as shown in FIG.6. The aeration fan 16 passes the air in the aeration way 122 from bottom up, by inhaling the air outside of the housing 12 from the vent 61, as shown in FIG.7. In FIG.6 and FIG.7, the flow of the air is shown by the solid line arrows.

The aeration fans 15 and 16 are arranged in the aeration way 123 as well as in the aeration way 122 (see FIG.4), and by these fans, the air in the aeration way 123 is passed from bottom up.

According to the above mentioned aeration fans 15 and 16, the heat emitted inside the aeration way 122 or 123 from the heat pipes 13 can be efficiently diffused outside of the housing 12. Therefore, the radiating efficiency of the heat pipe 13 and the radiating fin 14 are increased in the aeration way 122.

Further, in this embodiment, since the air in the aeration way 122 and 123 flow from bottom up, the air can flow efficiently upwards since the warm air has a natural tendency for going up. Therefore, the heat emitted to the aeration way 122 and 123 can be efficiently diffused to the outside of the housing 12.

In this embodiment, though the aeration fans 15 and 16 are used as blowing means to emit the air in the aeration way 122 or 123 outside of the housing 12, the other means may be adopted.

### (A heat collecting fin 17)

As shown in FIG.4, the heat collecting fin 17 is connected ranging over the heat pipes 13, in the accommodation room 121. The heat collecting fin 17 is comprised by a base 171 and a fin part 172 as shown in FIG.9. The base 171 extends over these heat pipes 13, and contacts each of them. The fin part 172 is connected perpendicularly to the surface of the base 171, and is stretched from one end of the base 171 to the other end in the longitudinal direction of the base 171.

According to the above mentioned heat collecting fin 17, the heat released out from the display panel 11 to the circulation path 92 can be collected efficiently, and can be lead to the heat pipe 13. When the temperature of the air in the circulation path 92 is lower than the reverse side of the display panel 11, the heat collecting fin 17 and the heat pipe 13 serve as a cooling means to cool the reverse side of the display panel 11.

In FIG.4, it is shown that the heat collecting fins 17 are connected only with the heat pipes in the aeration way 122 sides from the center. However, the heat collecting fins 17 are connected with the heat pipes 13 in the aeration way 123 sides as well.

In this embodiment, the heat collecting fin 17 is used as a heat collecting component which collects a heat from the air in the circulation path 92. Instead, the other heat collecting components may be used instead.

### (Heat insulating component 7)

As shown in FIG.14, a Heat insulating component 7 intervenes between the evaporator 191 and the display panel 11. The evaporator 191 is arranged at the back 111 side of the display panel 11, and the Heat insulating component 7 is arranged between the back 111 and the front 191a of the evaporator 191. A rubber such as a silicon or urethane may be used as a material for the Heat insulating component 7.

According to the Heat insulating component 7, it can prevent an over cooling of the display panel 11 near the evaporator 191. Therefore, the temperature distribution of the display panel 11 can be uniformalized, and can keep the display panel 11 good conditions.

### (A heat collecting fin 71 and a blowing fan 72 for circuit boards)

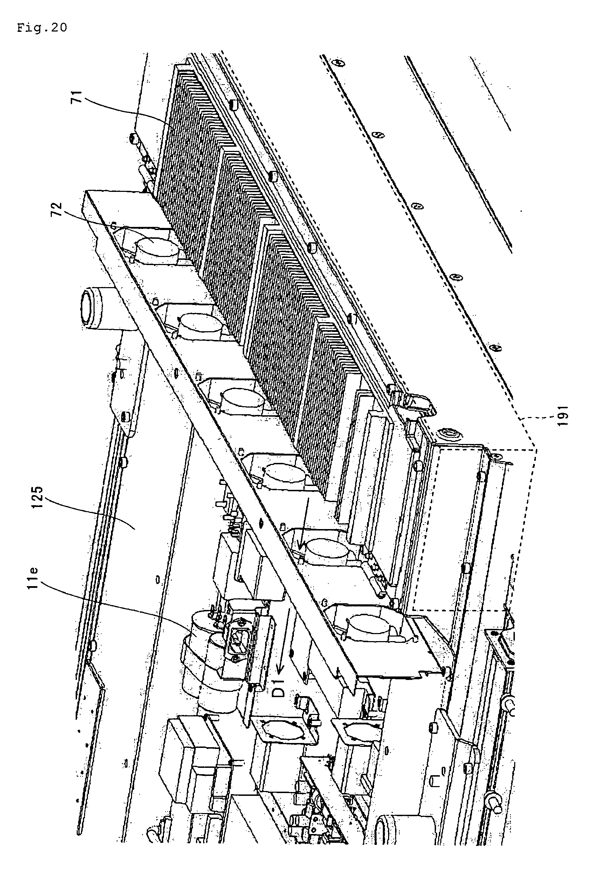

As shown in FIG.14 and FIG.20, the heat collecting fin 71 for circuit boards is arranged at the back side of the evaporator 191 among the back of the back wall 125. In other words, it is arranged near the lower end of the back wall 125. Thereby, the heat collecting fin 71 is arranged at the cooling area, which is an area cooled by the evaporator 191 among the back walls 125 of the accommodation room 121. The heat collecting fin 71 functions as a heat collecting means, and it collects heat from the air in the back side of the back wall 125.

Further, as shown in FIG.14 and FIG.20, the blowing fan 72 for circuit boards is arranged at the back of the back wall 125 near the upper part of the heat collecting fin 71. This blowing fan 72 functions as a blowing means, and passes the air in the back side of the cooling area of the back wall 125 along the back of the back wall 125. In this embodiment, as shown by an arrow D1 of FIG.20, the air in the back side of the cooling area is sent to the circuit board 11e by the blowing fan 72

According to the heat collecting fin 71, the heat can be collected from the air existing in the back side of the cooling area, and the heat is collected by the evaporator 191. Therefore, the air in the back side of the cooling area of the back wall 125 can be efficiently cooled with the evaporator 191.

Further, the cooled air is sent to the circuit board 11e which is arranged at the back of the back wall 125 by the blowing fan 72, and the heat generated in the circuit board 11e is collected by this air. As a result, the circuit board 11e is cooled efficiently.

In this embodiment, although the heat collecting fin 71 and the ventilation fan 72 for are used respectively for the heat collecting means and blowing means for cooling the circuit board 11e efficiently, other means may be used instead. Further, in this embodiment, the air in the back side of the cooling area of the back wall 125 is sent to the circuit board 11e by the blowing fan 72 (see FIG.20), the air near the circuit board 11e may be sent to the heat collecting fin 71 by the ventilation fan 72.

Further, the heat collecting fin 71 may be arranged on the evaporator 191, and under the blowing fan 72. Thereby, the heat collecting fin 71 functions as a fin which emits the cool air generated by the evaporator 191.

### [3. Composition for attaching the display apparatus to the support stand]

When installing a display apparatus, such as a liquid crystal display, outdoors, it can be considered to first install a support stand for supporting a display apparatus outdoors, and then attach the display apparatus to the support stand later. In this case, first you have to do a positioning of the unit, and then you have to fix the unit to the support stand while maintaining the position of the unit, when you attach the unit to the support stand. However, since the display apparatus installed in the outdoors are large, it is very difficult to perform an attachment as mentioned above. Therefore, a display system which can easily attach a display apparatus to the support stand is desired.

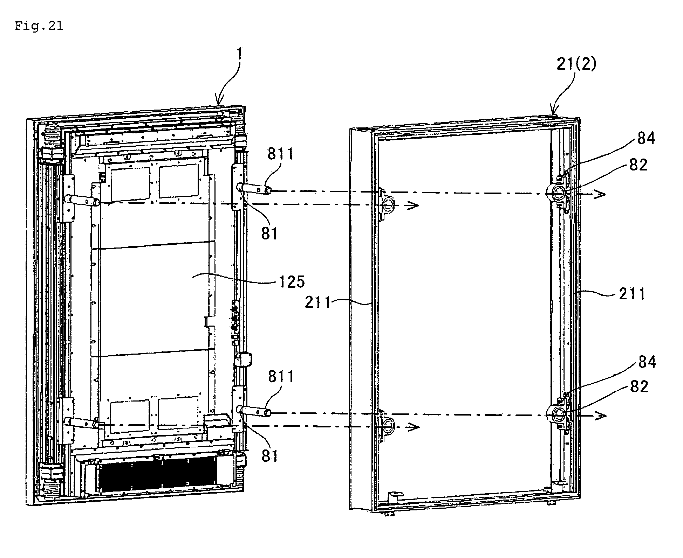

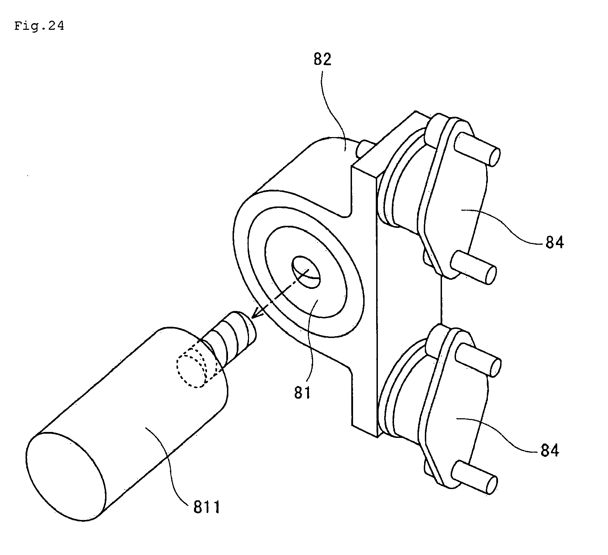

As shown in FIG.21, a pole shaped engaging component 81 which is protruded from the back of the display apparatus 1 is attached on the back of the display apparatus, and an extended component 811 for enlarging the protrusion from the back of the display apparatus 1 is attached on the tip of the engaging component 81 in detachable form. In detail, a male screw is formed in the base of the extended component 811 while a female screw is formed in the tip of the engaging component 81, and by thrusting the male screw to the female screw, the extended component 811 is attached at the tip of the engaging component 81 (see FIG.24). In this embodiment, four engaging components 81 are arranged at the back of the display apparatus 1, and these engaging components 81 are attached to the both side edge two by two, one on the top and the other on the bottom.

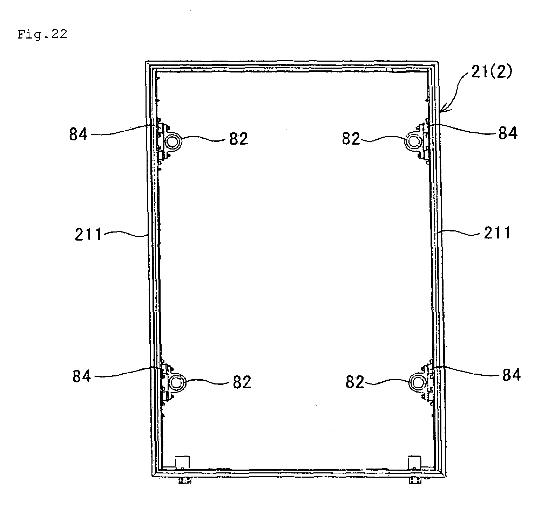

Further, as shown in FIG.22, a pair of side wall parts 211,211 of the frame part 21 has the ring like engaged component 82 attached on its inner circumference through the elastic rubber component 84. Here, the engaged component 82 is engaged to the engaging component 81 attached to the display apparatus 1. In this embodiment, as shown in FIG.22, four engaged components 82 are attached to the side wall parts 211,211 corresponding to each of the four engaging components 81 attached to the display apparatus 1.

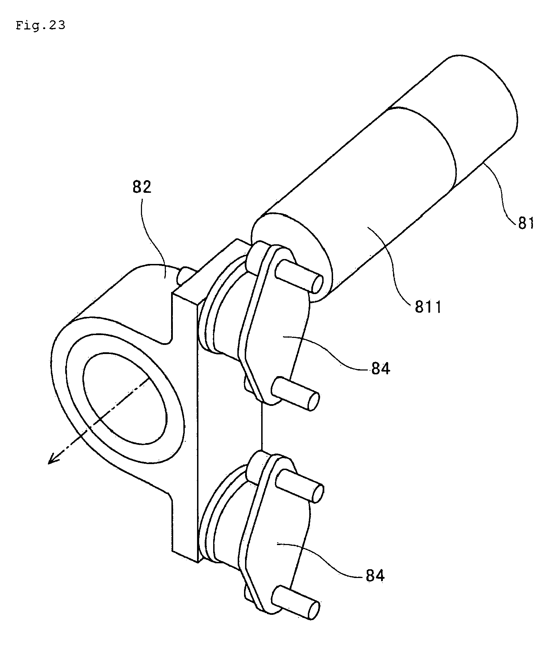

When attaching the display apparatus 1 to the support stand 2, first, the extended component 811 attached on the engaging component 81 is inserted to the corresponding engaged component 82 from the tip, as shown in FIG.21 and FIG.23. Then, the display apparatus 1 is pushed into the frame part 21.

Thereby, the engaging component 81 is guided to the engaged component 82 by the extended component 811, and fits into the engaged component 82. As a result, the engaging component 81 and the engaged component 82 are engaged in a condition where the display apparatus 1 is inserted to the frame part 21. Thus, the extended component 811 assists the insertion (or fitting) of the engaging component 81 to the engaged component 82.

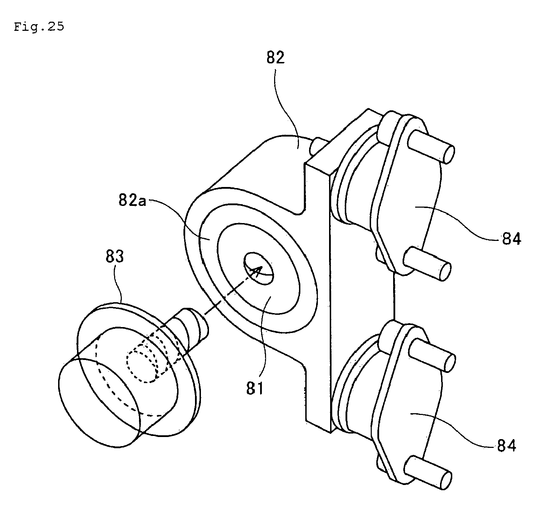

After the engaging component 81 is fitted to the engaged component 82, the extended component 811 is removed as shown in FIG.24. And as shown in FIG.25, the engagement sustaining component 83 is attached to the tip part of the engaging component 81 fitted to the engaged component 82 in a detachable form. In detail, a mail screw is formed in the engagement sustaining component 83, and thrusting the male screw into the female screw formed in the engaging component 81, the engagement sustaining component 83 is attached at the tip of the engaging component 81

When engagement sustaining component 83 is attached to the tip of the engaging component 81, it contacts the opening end side 82a of the engaged component 82. Thereby, the engaging of the engaging component 81 and the engaged component 82 is held by the engagement sustaining component 83.

According to the above mentioned structure, a position of the display apparatus 1 when inserted to the frame part 21 can be fixed only by engaging the engaging component 81 and the engaged component 82. Therefore, the positioning of the display apparatus 1 can be simplified. Further, by sustaining the engagement of the engaging component 81 and the engaged component 82 by the engagement sustaining component 83, the display apparatus 1 can be fixed to the support stand 2.

Further, in this embodiment, since the engaged component 82 is attached to the frame part 21 through the elastic component 84, even if a vibration is added to a display system, this vibration is absorbed by the elastic component 84. Therefore, transfer of the vibration to the display apparatus 1 from the frame part 21 can be prevented, and a breakage of the display apparatus 1 by vibration can be prevented. And a display apparatus can be easily attached to the support stand installed in the outdoors.

### [4. Arrangement of fluorescent light fittings]

As shown in FIG.12, the back wall 125 of the accommodation room 121 has the perpendicular wall part 125a and the inclination wall parts 125b and 125c. The wall part 125a is spread along the back 111 of the display panel 11. The wall part 125b is extended obliquely upward toward the backboard 3 side from the upper end of the wall part 125a. The wall part 125c is extended obliquely downward toward the backboard 3 side from the lower end of the wall part 125a.

Thereby, a first accommodation spaces 12b and 12c are formed between the back wall 125 and the back 111, along the surface of the wall parts 125b and 125c respectively. In other words, the first accommodation spaces 12b and 12c are formed in the upper end and the lower end of the path part 11c respectively. Further, between the back side wall 125 and the backboard 3, a second accommodation space 12a is formed along the back side of the wall part 125a.

Further, in the first accommodation space 12b, the circulating fan 18 is arranged as shown in FIG.12 and FIG.13, and in the first accommodation space 12c, the circulating fan 181 and the evaporator 191 are arranged as shown in FIG.12 and FIG.14. In the second accommodation space 12a, lighting equipment 5 for illuminating an advertising film is arranged, as shown in FIG.12. In detail, a plural fluorescent lights which constitutes lighting equipment 5 are horizontally located in a in the space 12a, along with the wall part 125a.

Thus, by forming the inclination wall parts 125b and 125c in the back wall 125, the first accommodation spaces 12b and 12c are formed inside the accommodation room 121, and the second accommodation space 12a is formed outside the room 121 below the circulating fan 18 and above the circulating fan 181 and the evaporator 191. In other words, the second accommodation space 12a exists between the first accommodation spaces 12b and 12c in the perpendicular direction. Therefore, the circulating fans 18,181, the evaporator 191, and the lighting equipment 5 can be arranged in a row in the perpendicular direction. As a result, it can avoid the display apparatus 1 expanded in the thickness direction.

### [5. Installation condition of a display system]

Conventionally, plane surface type displays, such as a liquid crystal displays are widely used as monitors for image displays. However, most of the conventional liquid crystal displays are designed for installing indoors, and measures for protecting them from rainstorms, dust, etc. are not taken. Therefore, it was difficult to install the conventional liquid crystal display permanently outdoors.

However, in recent years, it is considered to install a liquid crystal display in a stop of transportation facility, because of its small thickness and high resolution etc. If thickness is small, installation of the display to a narrow place such as bus stops is possible. If resolution is high, it can display a picture clearly, even if a display screen is small.

Therefore, in order to protect a liquid crystal display from a rainstorm or dust, it is considered to arrange a liquid crystal display (especially, a display panel which is easy to be damaged by rainstorms or dusts) inside an accommodation room having a waterproofing structure, to ease an installation of liquid crystal display to transportation stops.

However, when such a display apparatus is installed in the transportation stops, it may cause car accidents because the attention of vehicle drivers whom pass nearby may pay attention to the picture displayed on the screen.

Therefore, a waiting room unit for these stops which is hard for drivers to pay attention to the pictures of the display apparatus is desired. As shown in FIG.3, the above mentioned display system is installed in a waiting room unit 9. The waiting room unit 9 has a frame object 93 facing a waiting room space 91. The frame object 93 has a frame part forming the waiting room space 91 having a wall and a roof, and a side wall frame part 931 used as a support stand 2.

As shown in FIG.3, the display apparatus 1 is attached to the side wall frame part 931, and is installed in a state where a display screen 112a of a display panel 11 facing the waiting room space 91.

According to the above mentioned waiting room unit 9, since the display screen 112a is installed facing the waiting room space 91, it can offer various information to user waiting at the stop. Moreover, since the frame object is installed facing the waiting room space 91, the display screen 112a of the display panel 11 is not easily visible to the driver of the vehicles passing by the stop. Therefore, the driver's attention is distracted from the picture of the display screen 112a, and can reduce car accidents.

As shown in FIG.3, when the stop is placed along the passage 94 whose traffic direction 941 is limited to one way, it is desirable to install the side wall frame part 931 to the reverse side of the traffic direction 941, and to attach the display apparatus 1 to the side wall frame 931 toward the direction 941.

Here, the waiting room unit 9 shown in FIG.3 is formed along a right hand traffic road. If it is installed along a left hand traffic road, the waiting room unit 9 becomes a left right reversed form.

As described above, by installing the display apparatus 1 facing the waiting room space 91, the backboard 3 faces outside the waiting room space 91. Therefore, many kinds of information can be offered to the people or drives passing by the stop, by attaching advertising films on the backboard 3. In addition, even if it is seen from the drivers, if that is an advertising film (instead of the LCD displays etc.) the car accidents can be reduced.

If a displaying unit 1 is installed so that the display screen 112a turns the waiting room space 91, the heat collected by the air conditioner 19 is emitted towards the outside of the waiting room space 91 from the back 102 of a display system, as shown in an arrow D of FIG.3. Thereby, a hot wind does not blow to a man or woman waiting at the stop. Therefore, the user of the transportation system (waiting at the stop) does not feel uncomfortable.

### [6. Modification]

### (Modification 1)

According to the display apparatus 1 mentioned above, an iterative array of heat pipes 13 are arranged at a predetermined interval in the perpendicular direction (see FIG.4). However, the other forms may be applied. For example, heat pipes 13 may be arranged at different intervals. However, from a viewpoint of raising a cooling efficiency of the display apparatus 1, it is desirable to arrange heat pipes 13 all over the back 111 of the display panel 11 as in above mentioned display apparatus 1. Thereby, a heat can be collected from a whole back 111 side.

### (Modification 2)

According to the display apparatus 1 mentioned above, the air in the aeration way 122,123 are passed from bottom up by the aeration fans 15 and 16. Instead, the air may be passed from top down. For example, depending on the environment of the setting place, it might be desirable to pass the air in the aeration way 122,123 from top down.

Moreover, in the display apparatus 1 mentioned above, two aeration fans are arranged in each of the aeration ways 122 and 123. Instead, only one of them may be arranged. Or three or more fans may be arranged in each of the aeration ways.

Further, in the display apparatus 1, the aeration fans 15 are arranged at the upper ends 122a and 123a of the aeration ways 122 and 123, and the aeration fans 16 are arranged at the lower end parts 122b and 123b of the aeration ways 122 and 123, but they may be arranged at the other positions. However, they should be arranged so that the air in the aeration ways 122 and 123 can be emitted outside the housing 12.

### (Modification 3)

According to the display apparatus 1 mentioned above, the circulation path 92 is constituted from the path part 11a along the surface 112, the path part 11b along the upper side 113, the path part 11c along the back 111, and the path part 11d along the lower side 114. Instead, the other courses surrounding the display panel 11 in the accommodation room 121 may form the circulation path 92. For example, a path part may be formed between the side of the display panel 11, and the side walls 121a, 121b of the accommodation room 121, and the circulation path 92 may be formed by this path part and the path parts 11a, 11c.

Further, according to the display apparatus 1 mentioned above, the air in the path part 11a is passed from bottom up by circulating fan 18, but it may be passed from top down instead. In this case, it is desirable to install the circulating fan 18 near the bottom side 114 of the display panel 11. In addition, the circulating fan 18 maybe arranged at the other place than the upper side 113 or the lower side 114 of the display panel 11.

### (Modification 4)

According to the display apparatus 1 mentioned above, the circulating fan 181 is arranged above the evaporator 191. Instead the circulating fan 181 may be arranged under the evaporator 191.

In this case, since the circulating fan 181 inhales air from the evaporator 191, the air is sent to the evaporator 191 from above. Thus, the heat can be collected efficiently by the evaporator 191.

### (Modification 5)

According to the display apparatus 1 mentioned above, the radiating fin 14 is consisted by the first radiation part 141 and the second radiation part 142, and the protrusion part 131 of the heat pipe 13 is inserted from both sides by those radiation parts, while inserting the protrusion part 131 in a pair of grooves 141c and 142c. Instead, the radiating fin 14 may be consisted only by the first radiation part 141 for example, and the radiating fin 14 may be attached to the heat pipe 13 by fitting the protrusion part 131 to the groove 141c formed in the first radiation part 141.

According to this embodiment, the attachment of the radiating fin 14 to the heat pipe 13 can be simplified.

### (Modification 6)

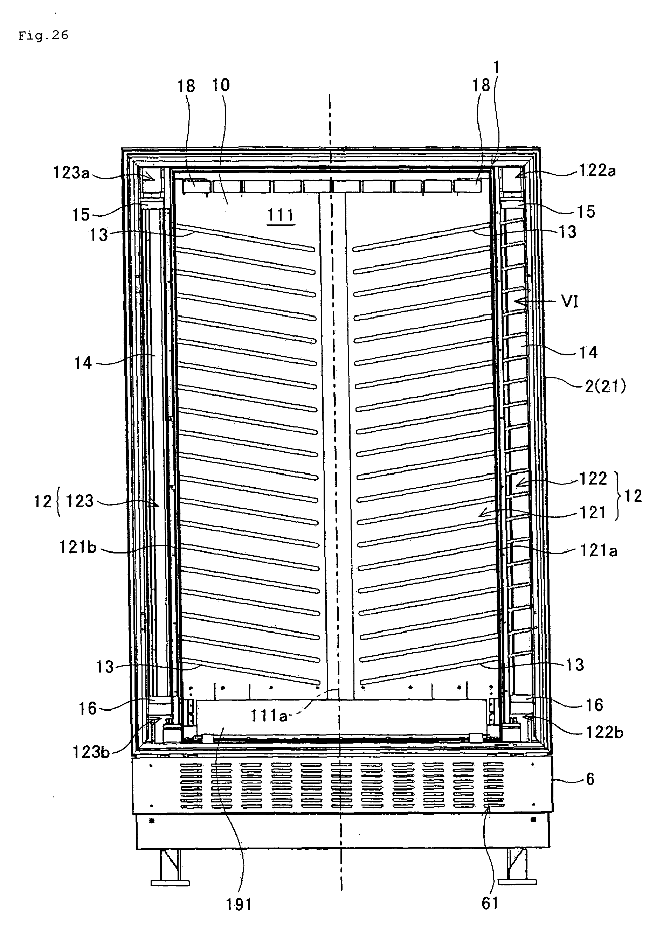

According to the display apparatus 1 mentioned above, the heat collecting fin 17 is connected over a plurality of heat pipes 13 in the accommodation room 121. Instead, other forms can be adopted. For example, as shown in FIG.26, the display apparatus 1 may be constituted without arranging the heat collecting fin 17.

The present invention is not limited to the foregoing embodiment but can be modified variously by one skilled in the art without departing from the spirit of the invention as set forth in the appended claims. For example, the technology mentioned above is applicable not only to the liquid crystal displays, but also to the other plane-surface type displays, such as plasma displays, or organic electroluminescence (Electro-Luminescence) displays.

## Claims

1. A display apparatus comprising:
a display panel,
an accommodating part accommodating the display panel,
a circulation path surrounding the accommodating part,
a heat exchanger collecting a heat from the circulation path,
an electronic circuit arranged at the back side of the accommodation room, controlling the display panel, wherein,
the circulation path exists between the accommodating part and the electronic circuit.

2. A display system comprising:
a display apparatus,
a frame,
an engaging component (81) arranged at the display apparatus,
an engaged component (82) arranged at the frame, which engages to the engaging component (81),
an engagement holding member (83) sustaining the engagement of the engaging component (81) and the engaged component (82), wherein,
the engaged component (82) fits to the engaging component (81) when the display apparatus is fitted to the frame.

3. A display system according to claim 2, wherein
the engaging component (81) is pole shaped,
the engaged component (82) is ring shaped, and
the engagement holding member (83) is removable from the tip of the component (81) inserted to the component (82), and contacts with the opening end side the to the component (82).

4. A display system according to claim 2, wherein
the engaging component (82) is attached to the frame part through an elastic component (84).

5. A display apparatus comprising:
a display panel,
a housing accommodating the display panel,
a circulation path surrounding the display panel,
a heat exchanger collecting a heat from the circulation path, wherein,
the circulation path has a first path on the surface side of the display panel and a second path on the back side of the display panel,
and the width of the first path is smaller than the second path.
